# EUROPÄISCHE PATENTSCHRIFT

(11) **EP 0 836 747 B1**
(45) Veröffentlichungstag und Bekanntmachung des Hinweises auf die Patenterteilung: **19.09.2001**
(21) Anmeldenummer: 96918610.5
(22) Anmeldetag: 25.06.1996
(51) Int. Cl.: H01L 21/8247, H01L 27/115

(54) **VERFAHREN ZUR HERSTELLUNG EINER FESTWERTSPEICHERZELLENANORDNUNG**
METHOD OF PRODUCING A READ-ONLY STORAGE CELL ARRANGEMENT
PROCEDE DE FABRICATION D'UN DISPOSITIF A CELLULES DE MEMOIRE ROM

(30) Priorität: 05.07.1995 DE 19524478
(43) Veröffentlichungstag der Anmeldung: 22.04.1998
(73) Patentinhaber: Infineon Technologies AG, 81669 München (DE)
(72) Erfinder: HOFMANN, Franz, D-80995 München (DE); RÖSNER, Wolfgang, D-81739 München (DE); KRAUTSCHNEIDER, Wolfgang, D-83104 Hohenthann (DE); RISCH, Lothar, D-85579 Neubiberg (DE)
(74) Vertreter: Zedlitz, Peter, Dipl.-Inf.
(86) Internationale Anmeldenummer: DE9601117
(87) Internationale Veröffentlichungsnummer: WO9702599

(56) Entgegenhaltungen:
- US-A- 5 049 956
- US-A- 5 180 680
- IBM TECHNICAL DISCLOSURE BULLETIN, Bd. 35, Nr. 4B, 1.September 1992, ARMONK NY, USA, Seiten 130-131, XP000313882 "VERTICAL EEPROM CELL"
- PATENT ABSTRACTS OF JAPAN vol. 012, no. 153 (E-607), 11.Mai 1988 & JP,A,62 269363 (NEC CORP), 21.November 1987,

## Beschreibung

Für viele Anwendungen werden Festwertspeicherzellenanordnungen mit elektrisch schreibbaren und elektrisch löschbaren Festwert-Speicherzellen in Siliziumtechnologie, sogenannte EEPROM, benötigt. In diesen EEPROM-Anordnungen bleiben die gespeicherten Daten auch ohne Spannungsversorgung erhalten.

Technisch werden diese Speicherzellen meist durch einen MOS-Transistor realisiert, der auf dem Kanalbereich ein erstes Dielektrikum, ein floatendes Gate, ein zweites Dielektrikum und ein Kontrollgate aufweist. Ist auf dem floatenden Gate eine Ladung gespeichert, so beeinflußt diese die Schwellenspannung des MOS-Transistors. In einer solchen Speicherzellenanordnung wird der Zustand "Ladung auf dem floatenden Gate" einem ersten logischen Wert, der Zustand "keine Ladung auf dem floatenden Gate" einem zweiten logischen Wert zugeordnet. Die Information wird in die Speicherzellen über einen Fowler-Nordheim-Tunnelstrom oder durch "Hot Electron" Strom, durch den Elektronen auf das floatende Gate injiziert werden, eingeschrieben. Gelöscht wird die Information durch einen Tunnelstrom durch das erste Dielektrikum. Es sind mindestens acht EEPROM-Transistoren in einer NAND-Anordnung hintereinander geschaltet.

Die MOS-Transistoren sind als planare MOS-Transistoren ausgebildet und in einer planaren Zellarchitektur angeordnet. Dadurch beträgt der minimale Flächenbedarf einer Speicherzelle 4F², wobei F die kleinste herstellbare Strukturgröße in der jeweiligen Technologie ist. Derzeit werden derartige EEPROM-Anordnungen für Datenmengen von maximal 32 Mbit angeboten.

In JP-OS 3-1574 ist eine elektrisch schreib- und löschbare Festwertspeicherzellenanordnung vorgeschlagen worden, die als Speicherzellen zu einer Hauptfläche eines Halbleitersubstrats vertikale MOS-Transistoren mit floatendem Gate und Kontrollgate umfaßt. In dem Substrat sind im wesentlichen parallel verlaufende streifenförmige Gräben vorgesehen. Die vertikalen MOS-Transistoren sind an den Flanken der Gräben angeordnet. Dabei sind die Speicherzellen jeweils an gegenüberliegenden Flanken der Gräben angeordnet. Am Grabenboden und an der Hauptfläche zwischen benachbarten Gräben verlaufen jeweils streifenförmige, dotierte Gebiete, die die Source- und Drain-Gebiete der MOS-Transistoren umfassen. Die Herstellung dieser streifenförmigen dotierten Gebiete erfolgt nach der Bildung der Gräben durch maskierte Implantationen. Wegen der unvermeidlichen Justierungenauigkeit beim Einsatz von Maskenschritten ist die erzielbare Packungsdichte in dieser Speicherzellenanordnung begrenzt.

In US-PS 5 049 956 ist eine elektrisch schreib- und löschbare Speicherzellenanordnung vorgeschlagen worden, die in punktförmigen Gräben angeordnete vertikale MOS-Transistoren mit Floatinggate und Kontrollgate umfaßt. Am Boden der Gräben ist eine durchgehende dotierte Schicht vorgesehen, die als gemeinsames Sourcegebiet aller MOS-Transistoren wirkt. Zur Erhöhung der Koppelkapazität ragen die Floatinggates über die Oberfläche des Substrats hinaus.

Größere Datenmengen können derzeit schreib- und löschbar nur in dynamischen Speicherzellenanordnungen (DRAM) oder auf magnetischen Datenträgern gespeichert werden. Ein DRAM benötigt zur Erhaltung der gespeicherten Daten ständig eine Spannungsversorgung. Magnetische Datenträger dagegen beruhen auf mechanischen Systemen mit rotierenden Speichermedien.

Der Erfindung liegt das Problem zugrunde, ein Verfahren zur Herstellung einer Festwertspeicherzellenanordnung anzugeben, die mit einem geringeren Flächenbedarf pro Speicherzelle herstellbar ist.

Dieses Problem wird erfindungsgemäß gelöst durch ein Verfahren zur Herstellung einer Festwertspeicherzellenanordnung gemäß Anspruch 1. Weitere Ausgestaltungen der Erfindung ergeben sich aus den übrigen Ansprüchen.

Die durch das erfindungsgemäße Verfahren hergestellte elektrisch schreib- und löschbare Festwertspeicherzellenanordnung ist in einem Halbleitersubstrat, vorzugsweise aus monokristallinem Silizium oder in einer Siliziumschicht eines SOI-Substrates, realisiert. An einer Hauptfläche des Halbleitersubstrats ist ein Zellenfeld mit Speicherzellen vorgesehen. Jede Speicherzelle umfaßt einen zur Hauptfläche vertikalen MOS-Transistor, der neben dem Source/Drain-Gebiet und einem dazwischen angeordneten Kanalgebiet ein erstes Dielektrikum, ein floatendes Gate, ein zweites Dielektrikum und ein Kontrollgate umfaßt.

Im Zellenfeld sind mehrere, im wesentlichen parallel verlaufende streifenförmige Gräben vorgesehen. Die vertikalen MOS-Transistoren sind an den Flanken der Gräben angeordnet. Dabei sind die Speicherzellen jeweils an gegenüberliegenden Flanken der Gräben angeordnet.

Am Grabenboden und an der Hauptfläche zwischen benachbarten Gräben verlaufen jeweils streifenförmige, dotierte Gebiete. Die an die jeweilige Flanke angrenzenden streifenförmigen, dotierten Gebiete bilden die Source/Drain-Gebiete der an der Flanke angeordneten MOS-Transistoren. Erstes Dielektrikum, floatendes Gate, zweites Dielektrikum und Kontrollgate sind jeweils entlang der Flanke zwischen den entsprechenden Source/Drain-Gebieten angeordnet. Entlang einer Flanke sind jeweils eine Vielzahl von Speicherzellen angeordnet. Das floatende Gate und das Kontrollgate von entlang einer Flanke benachbarten Speicherzellen sind gegeneinander isoliert.

Quer zu den Gräben verlaufen Wortleitungen, die jeweils mit Kontrollgates von vertikalen MOS-Transistoren verbunden sind, die unterhalb der jeweiligen Wortleitung angeordnet sind.

Vorzugsweise weisen die floatenden Gates in der Richtung senkrecht zur Hauptfläche eine größere Ausdehnung auf, als es der Tiefe der Gräben entspricht. Dadurch ragen die floatenden Gates über die Hauptfläche hinaus. Auf diese Weise wird die Koppelkapazität zwischen dem floatenden Gate und dem Kontrollgate vergrößert.

Wird der Abstand zwischen benachbarten Gräben im wesentlichen gleich der Breite der Gräben gewählt, so ist die erfindungsgemäße Festwertspeicherzellenanordnung in dem selbstjustierenden Herstellverfahren mit einem Platzbedarf pro Speicherzelle von 2F² herstellbar, wobei F die in der jeweiligen Technologie minimale Strukturgröße ist. Zur selbstjustierenden Herstellung der Festwertspeicherzellenanordnung werden nur zwei photolithographisch erzeugte Masken benötigt: eine Maske zur Grabenätzung, eine weitere Maske zur Strukturierung der quer zu den Gräben verlaufenden Wortleitungen. Die floatenden Gates werden durch eine Spacerätzung selbstjustiert zu den Flanken der Gräben gebildet. Parallel zum Verlauf der Gräben werden die floatenden Gates und das zweite Dielektrikum unter Verwendung der Wortleitungsmaske strukturiert.

Vorzugsweise wird die Spacerätzung zur Bildung der floatenden Gates vor der Entfernung der Grabenmaske durchgeführt. Die Ausdehnung der floatenden Gates senkrecht zur Hauptfläche ist dann über die Dicke der Grabenmaske einstellbar. Vor der Abscheidung einer zweiten dielektrischen Schicht zur Bildung des zweiten Dielektrikums wird die Grabenmaske entfernt.

In Fällen, in denen eine Vergrößerung der Koppelkapazität zwischen floatendem Gate und Kontrollgate durch Vergrößerung der Ausdehnung des floatenden Gates nicht erforderlich ist, wird die Grabenmaske vor der Abscheidung der ersten dotierten Polysiliziumschicht zur Bildung der floatenden Gates entfernt.

Im folgenden wird die Erfindung anhand eines Ausführungsbeispiels und der Figuren näher erläutert.
- Figur 1: zeigt ein Substrat mit einem dotierten Gebiet im Zellenfeld.
- Figur 2: zeigt das Substrat mit einer Grabenmaske nach der Ätzung von Gräben.
- Figur 3: zeigt das Substrat nach Bildung von streifenförmigen, dotierten Gebieten am Boden der Gräben.
- Figur 4: zeigt das Substrat nach Bildung eines ersten Dielektrikums und dotierter Polysiliziumspacer an den Flanken der Gräben.
- Figur 5: zeigt das Substrat nach Abscheidung einer zweiten dielektrischen Schicht und einer zweiten dotierten Polysiliziumschicht.
- Figur 6: zeigt eine Aufsicht auf die fertige elektrisch schreib- und löschbare Festwertspeicherzellenanordnung.

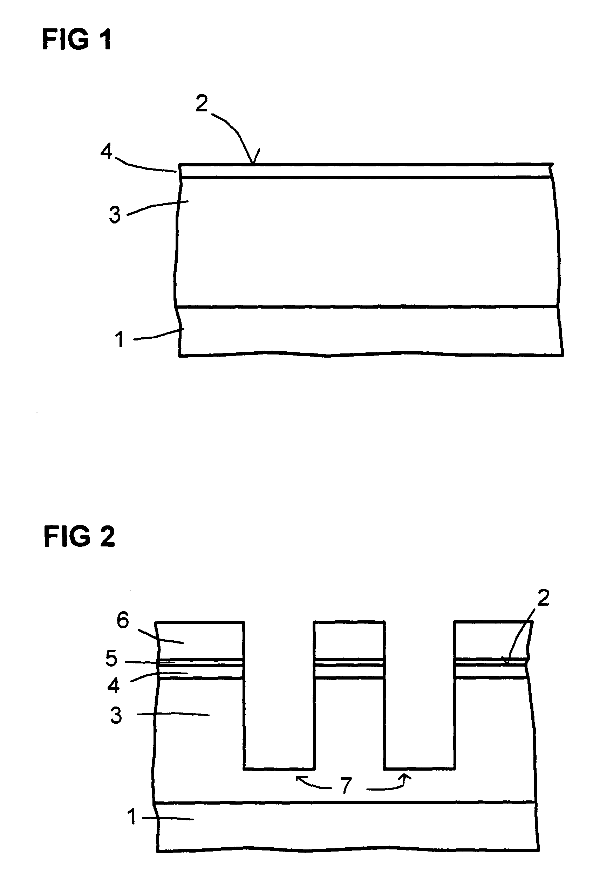

Ein Substrat 1 aus zum Beispiel p-dotiertem monokristallinem Silizium mit einer Dotierstoffkonzentration von 5 x 10¹⁵ cm⁻³ wird an einer Hauptfläche 2 mit einem Streuoxid in einer Dikke von zum Beispiel 50 nm (nicht dargestellt) versehen. Durch Implantation mit Bor (160 keV, 6 x 10¹³ cm⁻²) und anschließendes Tempern wird eine p-dotierte Wanne 3 mit einer Dotierstoffkonzentration von 3 x 10¹⁷ cm⁻³ erzeugt (siehe Figur 1). Anschließend wird das Streuoxid durch Ätzen entfernt.

Am Rand der p-dotierten Wanne 3 wird nachfolgend zum Beispiel in einem LOCOS-Prozeß eine Isolationsstruktur gebildet (nicht dargestellt). Die Isolationsstruktur definiert den Bereich für ein Zellenfeld.

Nach Bildung eines weiteren, 20 nm dicken Streuoxids (nicht dargestellt) wird durch Implantation mit Arsen, 50 keV, 5 x 10¹⁵ cm⁻² ein n⁺-dotiertes Gebiet 4 erzeugt. Das n⁺-dotierte Gebiet 4 weist eine Dotierstoffkonzentration von 1 x 10²¹ cm⁻³ auf. Es-erstreckt sich an der Hauptfläche 2 über den Bereich für das Zellenfeld. Die Tiefe des n⁺-dotierten Gebietes 4 beträgt zum Beispiel 200 nm.

Nach Entfernen des Streuoxids wird an der Hauptfläche 2 durch eine thermische Oxidation bei zum Beispiel 800°C eine Schicht aus SiO₂ in einer Dicke von zum Beispiel 50 nm und durch CVD Abscheidung eine Nitridschicht in einer Dicke von 50 nm gebildet. Die Schicht aus SiO₂ und die Nitridschicht bilden eine Hilfsschicht 5 (siehe Figur 2).

Anschließend wird zur Bildung einer Grabenmaske 6 in einem TEOS-Verfahren eine 300 nm dicke SiO₂-Schicht abgeschieden und mit Hilfe photolithographischer Verfahren durch anisotropes Trockenätzen zum Beispiel mit CHF₃, O₂ strukturiert.

Nachfolgend wird durch anisotropes Trockenätzen die Hilfsschicht 5 entsprechend der Grabenmaske 6 strukturiert. Das Ätzen der Hilfsschicht 5 erfolgt zum Beispiel mit CHF₃, O₂. Nach Entfernen einer Photolackmaske, die zur Strukturierung der Grabenmaske 6 aufgebracht wurde, wird eine Grabenätzung durchgeführt. Die Grabenätzung erfolgt in einem anisotropen Trockenätzprozeß mit zum Beispiel HBr, He, O₂, NF₃. Dabei werden Gräben 7 erzeugt, die_eine Tiefe von zum Beispiel 0,6 µm aufweisen. Die Gräben 8 erstrecken sich über einen Block des NAND-Zellenfeldes. Sie weisen eine Länge von zum Beispiel 8 µm und eine Breite von zum Beispiel 0,4 µm auf. Im Zellenfeld sind benachbarte Gräben 7 in einem Abstand von 0,4 µm angeordnet. Die Gräben 7 verlaufen im wesentlichen parallel.

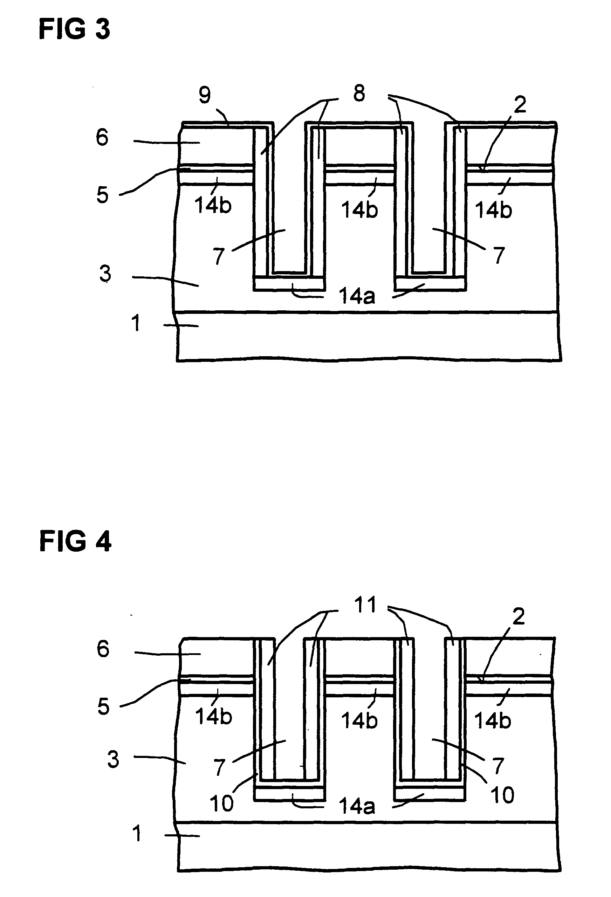

Durch konforme Abscheidung wird eine 20 nm dicke TEOS-Schicht (nicht dargestellt) und dann eine Si₃N₄-Schicht in einer Dikke von zum Beispiel 80 nm erzeugt. Durch anschließendes anisotropes Trockenätzen mit CHF₃, O₂ werden an senkrechten Flanken der Gräben 7 und der Grabenmaske 6 Si₃N₄-Spacer 8 gebildet (siehe Figur 3).

Anschließend wird ganzflächig in einem TEOS-Verfahren eine Streuoxidschicht 9 in einer Dicke von 20 nm abgeschieden. Es wird eine Ionenimplantation mit As (5 x 10¹⁵ cm⁻², 50 keV) durchgeführt, bei der am Boden der Gräben 7 n⁺-dotierte, streifenförmige Gebiete 14a gebildet werden. Die dotierten Gebiete 14a werden durch einen Temperschritt aktiviert. In den streifenförmigen, dotierten Gebieten 14a wird eine Dotierstoffkonzentration von zum Beispiel 1 x 10²¹ cm⁻³ eingestellt.

Die Si₃N₄-Spacer 8 maskieren die Flanken der Gräben 7 bei der Ionenimplantation. Dadurch wird eine Einsatzspannungsverschiebung der an den Flanken der Gräben 7 entstehenden, vertikalen MOS-Transistoren vermieden.

An der Hauptfläche 2 des Halbleitersubstrats 1 sind bei der Grabenätzung durch Strukturierung des n⁺-dotierten Gebietes 4 zwischen benachbarten Gräben 7 streifenförmige, dotierte Gebiete 14b entstanden.

Anschließend wird das Streuoxid 9 zum Beispiel in einem HF-Dip entfernt. Durch naßchemisches Ätzen zum Beispiel mit H₃PO₄ werden die Si₃N₄-Spacer 8 entfernt. Danach wird die dünne Oxidunterlage naßchemisch mit HF entfernt. Nun liegen in den Gräben 7 an den Flanken und am Boden Siliziumoberflächen frei.

Durch thermische Oxidation zum Beispiel bei 800°C wird mindestens an den freiliegenden Siliziumflächen eine erste dielektrische Schicht 10 aus SiO₂ gebildet. Die erste dielektrische Schicht 10 wird an den Flanken mit einer Dicke von zum Beispiel 10 nm gebildet. Wegen der erhöhten Dotierung der streifenförmigen, dotierten Gebiete 14a am Boden der Gräben 7 entsteht die erste dielektrische Schicht dort in einer Dicke von 50 nm.

Durch Abscheidung einer in situ dotierten Polysiliziumschicht in einer Dicke von zum Beispiel 100 nm und anschließendes anisotropes Rückätzen werden an den Flanken der Gräben dotierte Polysiliziumspacer 11 erzeugt (siehe Figur 4).

Zur Bildung der dotierten Polysiliziumspacer 11 kann auch eine undotierte Polysiliziumschicht abgeschieden werden, die anschließend durch Belegung dotiert wird.

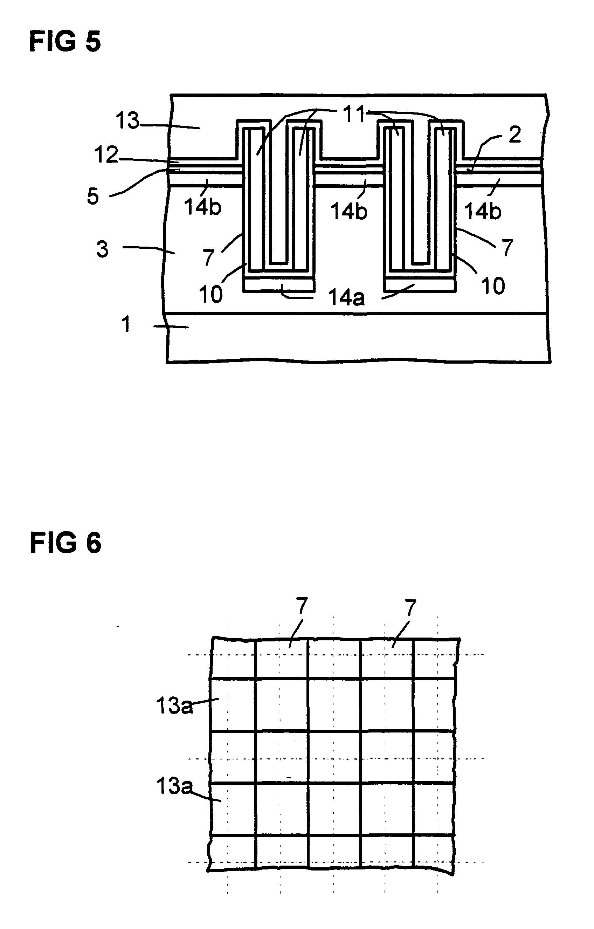

Die Grabenmaske 6 wird nachfolgend durch nasses Ätzen zum Beispiel mit HF-Dampf entfernt. Bei dieser Ätzung wird in einem TEOS-Verfahren abgeschiedenes SiO₂ selektiv zu thermischem SiO₂ entfernt. Die Hilfsschicht 5 und die erste dielektrische Schicht 10 an der Oberfläche der streifenförmigen dotierte Gebiete 14a, b wird bei dieser Ätzung nicht angegriffen (siehe Figur 5). Diese Ätzung ist ferner selektiv in bezug auf Polysilizium. Die dotierten Polysiliziumspacer 11 ragen nach Entfernen der Grabenmaske 6 über die Hauptfläche 3 hinaus. Die Ausdehnung der Polysiliziumspacer 11 in zur Hauptfläche 2 vertikaler Richtung ist durch die Dicke der Grabenmaske 6 gegeben.

Anschließend wird ganzflächig eine zweite dielektrische Schicht 12 erzeugt. Die zweite dielektrische Schicht 12 wird als Mehrfachschicht aus einer ersten SiO₂-Schicht, einer Si₃N₄-Schicht und einer zweiten SiO₂-Schicht gebildet. Dabei. wird die Si₃N₄-Schicht in einem CVD-Verfahren abgeschieden, die erste und zweite SiO₂-Schicht wird durch thermische Oxidation gebildet. Die zweite dielektrische Schicht 12 wird in einer Dicke von 8 nm gebildet.

Anschließend wird eine zweite dotierte Polysiliziumschicht 13 abgeschieden. Die zweite dotierte Polysiliziumschicht 13 wird in situ dotiert abgeschieden. Sie wird in einer Dicke von zum Beispiel 500 nm abgeschieden. Die zweite dotierte Polysiliziumschicht 13 füllt die Gräben 7 vollständig auf. Sie füllt ebenfalls den Zwischenraum zwischen benachbarten Polysiliziumspacern 11 an der Hauptfläche 2 auf.

Nachfolgend wird eine Wortleitungsmaske durch Abscheidung einer TEOS-SiO₂-Schicht in einer Dicke von zum Beispiel 100 nm und Strukturierung der TEOS-SiO₂-Schicht mit Hilfe photolithographischer Prozeßschritte gebildet (nicht dargestellt). Die Wortleitungsmaske definiert quer zu den Gräben 7 verlaufende Wortleitungen. Unter Verwendung der Wortleitungsmaske als Ätzmaske wird die zweite Polysiliziumschicht 13 in einem anisotropen Trockenätzverfahren zum Beispiel mit HBr, Cl₂, He strukturiert. Dabei entstehen quer zu den Gräben 7 verlaufende Wortleitungen 13a (siehe Aufsicht in Figur 6) und im Bereich der Gräben 7 Kontrollgates. Die Ätzung wird unterbrochen, sobald die Oberfläche der zweiten dielektrischen Schicht 12 freigelegt ist.

Anschließend wird in einem weiteren Trockenätzverfahren die zweite dielektrische Schicht 12, beispielsweise bei ONO mit CHF₃, O₂ geätzt. Nun wird wieder mit hoher Selektivität zu (Oxid/Nitrid) das Polysilizium geätzt (HBr, Cl₂, He). Hierbei wird nun auch das floating Gate und das Kontrollgate bis auf den Boden des Grabens geätzt. Bei dieser Ätzung werden aus dem dotierten Polysiliziumspacer 11 floatende Gates gebildet.

Anschließend wird durch nasses Ätzen zum Beispiel mit HF, H₃PO₄ die zweite dielektrische Schicht 12 entfernt.

Bei der Strukturierung der dotierten Polysiliziumspacer 11, der zweiten dielektrischen Schicht 12 und der zweiten dotierten Polysiliziumschicht 13 entsprechend dem Verlauf der Wortleitungen 13a wird zwischen benachbarten Wortleitungen 13a die erste dielektrische Schicht 10 in den Gräben 7 freigelegt. Das heißt, zwischen benachbarten Wortleitungen 13a sind die Gräben 7, bis auf die erste dielektrische Schicht 10, geöffnet. Dieser Zwischenraum wird anschließend durch Abscheidung einer TEOS-SiO₂-Schicht in einer Schichtdicke von zum Beispiel 800 nm und Rückätzen der TEOS-SiO₂-Schicht bis zum Freilegen der Oberfläche der Wortleitungen 13a aufgefüllt (nicht dargestellt).

Schließlich wird ganzflächig eine planarisierende Zwischenoxidschicht, zum Beispiel aus Borphosphorsilikatglas, abgeschieden , in der Kontaktlöcher geöffnet werden. Kontaktlöcher werden unter anderem zu den Wortleitungen 13a, zu den streifenförmigen dotierten Gebieten 14a, die am Boden der Gräben 7 angeordnet sind, und zu den streifenförmigen, dotierten Gebieten 14b, die an der Hauptfläche 2 zwischen benachbarten Gräben 7 angeordnet sind, geöffnet. Die Kontaktlöcher werden zum Beispiel mit Aluminium aufgefüllt. Es folgt die Erzeugung einer Metallisierungsebene zum Beispiel durch Abscheidung und Strukturierung einer Aluminiumschicht. Schließlich wird eine Passivierungsschicht aufgebracht. Diese Standardschritte sind nicht im einzelnen dargestellt.

In der erfindungsgemäß hergestellten Festwertspeicherzellenanordnung erfolgt die Bewertung der einzelnen Speicherzellen nach dem "Virtual ground"-Prinzip. Jedes der streifenförmigen, dotierten Gebiete 14a, 14b ist zwei Reihen von Speicherzellen zugeordnet. Ein Paar der streifenförmigen dotierten Gebiete 14a, 14b, das aus benachbart angeordneten dotierten Gebieten an der Hauptfläche 14a und am Boden 14b zusammengesetzt ist, ist dabei eindeutig einer Reihe Speicherzellen zugeordnet. Beim Auslesen der Festwertspeicherzellenanordnung wird daher nach Auswahl über die Wortleitung 13a der Stromfluß zwischen einem streifenförmigen dotierten Gebiet 14a am Boden eines Isolationsgrabens und einem benachbarten streifenförmigen dotierten Gebiet 14b an der Hauptfläche 2 bewertet. Die streifenförmigen, dotierten Gebiete 14a, 14b am Boden der Gräben 7 und an der Hauptfläche 2 wirken je nach Beschaltung als Referenz - oder als Bitleitung.

Die Information wird in die Speicherzellen, wie bei EEPROM-Anordnungen üblich, durch "hot Electron" Injektion eingeschrieben. Das Löschen der Speicherzellen erfolgt in einem Fowler-Nordheim-Prozeß.

Zur Programmierung werden die dotierten, streifenförmigen Gebiete 14a, b links von einem Auswahltransistor auf eine erste Versorgungsspannung, zum Beispiel V_{dd}, und die dotierten, streifenförmigen Gebiete 14a, b rechts des Auswahltransistors auf eine zweite Versorgungsspannung, zum Beispiel Vₛₛ gelegt. An dem im Graben 7 angeordneten Teil der Wortleitung 13a, der als Kontrollgate wirkt, wird eine hohe Gatespannung von zum Beispiel 7 Volt angelegt. Dadurch werden Elektronen in das zugehörige floatende Gate injiziert.

Zum Löschen der Information werden die floatenden Gates durch einen Fowler-Nordheim-Prozeß zum Substrat hin entladen.

Figur 6 zeigt eine Aufsicht auf das Zellenfeld der erfindungsgemäßen Festwertspeicherzellenanordnung. Die Zellengröße der Speicherzellen ist als strichpunktierte Linie eingetragen. Die Breite der Speicherzellen setzt sich zusammen aus einer halben Breite des Grabens 7 sowie dem halben Abstand zwischen benachbarten Gräben. Die Länge einer Speicherzelle setzt sich zusammen aus der Breite der Wortleitung 13a sowie zweimal dem halben Abstand zwischen benachbarten Wortleitungen 13a. Werden die Gräben 7 mit einer Breite von F und in einem Abstand von F gebildet und werden die Wortleitungen 13a in einer Breite von F und einem Abstand von F gebildet, wobei F die in der jeweiligen Technologie minimale Strukturgröße ist, so ergibt sich eine Speicherzellenfläche von 2F².

## Patentansprüche

1. Verfahren zur Herstellung einer Festwertspeicherzellenanordnung,
- bei dem an einer Hauptfläche (2) eines Halbleitersubstrats (1) ein Zellenfeld mit Speicherzellen, die jeweils einen zur Hauptfläche (2) vertikalen MOS-Transistor mit einem ersten Dielektrikum (10), einem floatenden Gate (11), einem zweiten Dielektrikum (12) und einem Kontrollgate (13a) umfassen, gebildet wird,
- bei dem das Halbleitersubstrat (1) mindestens im Bereich des Zellenfeldes von einem ersten Leitfähigkeitstyp dotiert ist,
- bei dem zur Bildung des Zellenfeldes an der Hauptfläche (2) des Halbleitersubstrats (1) ein vom zweiten Leitfähigkeitstyp dotiertes Gebiet (4) erzeugt wird, das sich über das gesamte Zellenfeld erstreckt,
- bei dem eine Grabenmaske (6) erzeugt wird,
- bei dem in einem anisotropen Trockenätzprozeß unter Verwendung der Grabenmaske (6) als Ätzmaske in der Hauptfläche (2) mehrere, im wesentlichen parallel verlaufende, streifenförmige Gräben (7) geätzt werden, wobei an der Hauptfläche (2) zwischen benachbarten Gräben (7) angeordnete, streifenförmige vom zweiten Leitfähigkeitstyp dotierte Gebiete (14b) durch Strukturierung des vom zweiten Leitfähigkeitstyp dotierten Gebietes (4) gebildet werden,
- bei dem am Boden der Gräben (7) angeordnete streifenförmige vom zweiten Leitfähigkeitstyp dotierte Gebiete (14a) durch Ionenimplantation gebildet werden, wobei die Grabenmaske (6) als Implantationsmaske wirkt,
- bei dem an den gegenüberliegenden Flanken der Gräben (7) jeweils das erste Dielektrikum (10), das floatende Gate (11), das zweite Dielektrikum (12) und das Kontrollgate (13a) für die vertikalen MOS-Transistoren gebildet werden,
- bei dem das floatende Gate (11) und das Kontrollgate (13a) von entlang einer Flanke benachbarten MOS-Transistoren gegeneinander isoliert werden,
- bei dem quer zu den Gräben (7) verlaufende Wortleitungen (13a) erzeugt werden, die jeweils mit den Kontrollgates (13a) der unterhalb der jeweiligen Wortleitung (13a) angeordneten vertikalen MOS-Transistoren verbunden sind.

2. Verfahren nach Anspruch 1,
bei dem vor der Ionenimplantation zur Bildung der am Boden der Gräben (7) angeordneten streifenförmigen dotierten Gebiete (14a) die Seitenwände der Gräben (7) mit maskierenden Spacern (8) bedeckt werden, die nach der Ionenimplantation entfernt werden.

3. Verfahren nach Anspruch 1 oder 2,
- bei dem nach der Bildung der streifenförmigen dotierten Gebiete (14a, 14b) eine erste dielektrische Schicht (10) erzeugt wird, die mindestens die Flanken der Gräben (7) bedeckt,
- bei dem auf der ersten dielektrischen Schicht (10) eine erste dotierte Polysiliziumschicht erzeugt wird,
- bei dem durch anisotropes Ätzen aus der ersten dotierten Polysiliziumschicht dotierte Polysiliziumspacer, (11) gebildet werden,
- bei dem eine zweite dielektrische Schicht (12) erzeugt wird,
- bei dem eine zweite dotierte Polysiliziumschicht (13) erzeugt wird,
- bei dem durch Strukturierung der zweiten Polysiliziumschicht (13) mit Hilfe einer Wortleitungsmaske die Wortleitungen (13a) und Kontrollgates (13a) gebildet werden,
- bei dem durch Strukturierung der zweiten dielektrischen Schicht (12) und der dotierten Polysiliziumspacer (11) jeweils das zweite Dielektrikum und das floatende Gate für die MOS-Transistoren gebildet werden.

4. Verfahren nach Anspruch 3,
bei dem die Grabenmaske (6) nach der Bildung der dotierten Polysiliziumspacer (11) entfernt wird.

## Claims

1. Method for the production of a read-only memory cell arrangement,
- in which a cell array, having memory cells which each comprise an MOS transistor, vertical to the main face (2) and with a first dielectric (10), a floating gate (11), a second dielectric (12) and a control gate (13a), is formed on a main surface (2) of a semiconductor substrate (1),
- in which the semiconductor substrate (1) is doped with a first conductivity type at least in the region of the cell array,
- in which, in order to form the cell array, a region (4), doped with the second conductivity type and extending over the entire cell array, is produced on the main surface (2) of the semiconductor substrate (1),
- in which a trench mask (6) is produced,
- in which a plurality of essentially parallel strip-shaped trenches (7) are etched in the main surface (2) in an anisotropic dry etching process, with the trench mask (6) being used as an etching mask, strip-shaped regions (14b), arranged on the main surface (2) between neighbouring trenches (7) and doped with the second conductivity type, being formed by structuring the region (4) doped with the second conductivity type,
- in which strip-shaped regions (14a), arranged at the bottom of the trenches (7) and doped with the second conductivity type, are formed by ion implantation, the trench mask (6) acting as an implantation mask,
- in which the first dielectric (10), the floating gate (11), the second dielectric (12) and the control gate (13a) for the vertical MOS transistors are in each case formed on the opposite flanks of the trenches (7),
- in which the floating gate (11) and the control gate (13a) of neighbouring MOS transistors along a flank are insulated from each other,
- in which word lines (13a) are produced, extending transversely to the trenches (7) and in each case connected to the control gates (13a) of the vertical MOS transistors arranged below the respective word line (13a).

2. Method according to Claim 1,
- in which, before the ion implantation for forming the strip-shaped doped regions (14a) arranged at the bottom of the trenches (7), the side walls of the trenches (7) are covered with masking spacers (8) which are removed after the ion implantation.

3. Method according to Claim 1 or 2,
- in which, after the strip-shaped doped regions (14a, 14b) have been formed, a first dielectric layer (10) which covers at least the flanks of the trenches (7) is produced,
- in which a first doped polysilicon layer is produced on the first dielectric layer (10).
- in which doped polysilicon spacers (11) are formed by anisotropic etching from the first doped polysilicon layer,
- in which a second dielectric layer (12) is produced,
- in which a second doped polysilicon layer (13) is produced,
- in which the word lines (13a) and control gates (13a) are formed by structuring the second polysilicon layer (13) with the aid of a word-line mask,
- in which the second dielectric and the floating gate for the MOS transistors are in each case formed by structuring the second dielectric layer (12) and the doped polysilicon spacers (11).

4. Method according to Claim 3,
- in which the trench mask (6) is removed after the doped polysilicon spacers (11) have been formed.

## Revendications

1. Procédé de fabrication d'un dispositif de cellules de mémoire morte,
- dans lequel on forme sur une surface (2) principale d'un substrat (1) semi-conducteur un champ de cellules comportant des cellules de mémoire qui comprennent chacune un transistor MOS vertical par rapport à la surface (2) principale, comportant un premier diélectrique (10), une grille (11) flottante, un deuxième diélectrique (12) et une grille (13a) de contrôle,
- dans lequel on dope le substrat (1) semi-conducteur, au moins dans la zone du champ de cellules, d'un premier type de conductivité,
- dans lequel, pour former le champ de cellules sur la surface (2) principale du substrat (1) semi-conducteur, on produit une deuxième région (4) dopée d'un deuxième type de conductivité, qui s'étend sur tout le champ de données,
- dans lequel on produit un masque (6) pour sillons,
- dans lequel on ménage par une opération d'attaque chimique anisotrope en voie sèche, en utilisant le masque (6) pour sillons comme masque d'attaque chimique, dans la surface (2) principale plusieurs sillons (7) en forme de bandes s'étendant parallèlement, des régions (14b) dopées en forme de bandes, disposées entre des sillons (7) voisins, du deuxième type de conductivité étant formées par structuration de la région (4) dopée du deuxième type de conductivité,
- dans lequel on forme par implantation ionique des régions (14a) dopées en forme de bandes, disposées au fond des sillons (7), du deuxième type de conductivité, le masque (6) pour sillons servant de masque d'implantation,
- dans lequel on forme sur les flancs opposés des sillons (7) chaque fois le premier diélectrique (10), la grille (11) flottante, le deuxième diélectrique (12) et la grille (13a) de contrôle pour les transistors MOS verticaux,
- dans lequel on isole l'une de l'autre la grille (11) flottante et la grille (13a) de contrôle de transistors MOS voisins le long d'un flanc,
- dans lequel on produit des lignes (13a) de transmission de mots, qui s'étendent transversalement aux sillons (7) et qui sont reliées respectivement à la grille (13a) de contrôle de transistors MOS verticaux qui sont disposés en-dessous de la ligne (13a) de transmission mots associée.

2. Procédé suivant la revendication 1, dans lequel, avant l'implantation ionique pour former les régions (14a) dopées en forme de bandes disposées au fond des sillons (7), on recouvre les parois latérales des sillons (7) d'espaceurs (8) masquants que l'on enlève après l'implantation ionique.

3. Procédé suivant la revendication 1 ou 2,
- dans lequel, après la formation des régions (14a, 14b) dopées en forme de bandes, on produit une première couche (10) diélectrique qui recouvre au moins les flancs des sillons (7),
- dans lequel on produit sur la première couche (10) diélectrique une première couche en polysilicium dopé,
- dans lequel on forme par attaque chimique anisotrope des espaceurs (11) en polysilicium dopé dans la couche en polysilicium dopé,
- dans lequel on produit une deuxième couche (12) diélectrique,
- dans lequel on produit une deuxième couche (13) en polysilicium dopé,
- dans lequel on forme par structuration de la deuxième couche (13) en polysilicium, à l'aide d'un masque pour lignes de transmission de mots, les lignes (13a) de transmission de mots et les grilles (13a) de contrôle,
- dans lequel on forme par structuration de la deuxième couche (12) diélectrique et des espaceurs (11) en polysilicium dopé respectivement le deuxième diélectrique et la grille flottante pour les transistors MOS.

4. Procédé suivant la revendication 3, dans lequel on enlève le masque (6) pour sillons après la formation des espaceurs (11) en polysilicium dopé.
